# EUROPÄISCHE PATENTANMELDUNG

(11) **EP 4 455 891 A2**
(43) Veröffentlichungstag der Anmeldung: **30.10.2024**
(21) Anmeldenummer: 24159546.1
(22) Anmeldetag: 26.02.2024
(51) Int. Cl.: G06F 11/36

(54) **COMPUTERIMPLEMENTIERTES VERFAHREN UND SYSTEM ZUM ERSTELLEN EINER SZENARIEN-BIBLIOTHEK**

(30) Priorität: 06.03.2023 DE 102023105379
(71) Anmelder: dSPACE GmbH, 33102 Paderborn (DE)
(72) Erfinder: Püschl, Thorsten, 33102 Paderborn (DE); Haupt, Hagen, 33102 Paderborn (DE); Stavesand, Jann-Eve, 33102 Paderborn (DE)

(57) **Zusammenfassung**

Die Erfindung betrifft ein computerimplementiertes Verfahren und System zum kriterienbasierten Erstellen einer, virtuelle Fahrzeugumgebungen aufweisenden, Szenarien-Bibliothek (10) zum Testen hochautomatisierter Fahrfunktionen eines Kraftfahrzeugs, mit Ermitteln (S2), unter Verwendung vorgegebener Kriterien, eines, eine Fahrsituation von Interesse (14) repräsentierenden, durch die Sensordaten (12) umfassten ersten Szenario-Datensatzes (16); Vergleichen (S3) des, die Fahrsituation von Interesse (14) repräsentierenden ersten Szenario-Datensatzes (16) mit von der Szenarien-Bibliothek (10) umfassten zweiten Szenario-Datensätzen (18). Die Erfindung betrifft ferner ein computerimplementiertes Verfahren zur Validierung einer Modellgüte eines Simulationsmodells zum Ausführen einer hochautomatisierten Fahrfunktionen eines Kraftfahrzeugs.

## Beschreibung

Die vorliegende Erfindung betrifft ein computerimplementiertes Verfahren zum kriterienbasierten Erstellen einer, virtuelle Fahrzeugumgebungen aufweisenden, Szenarien-Bibliothek zum Testen hochautomatisierter Fahrfunktionen eines Kraftfahrzeugs.

Die vorliegende Erfindung betrifft des Weiteren ein computerimplementiertes Verfahren zur Validierung einer Modellgüte eines Simulationsmodells zum Ausführen eines virtuellen Tests einer hochautomatisierten Fahrfunktionen eines Kraftfahrzeugs.

Die Erfindung betrifft ferner ein System zum kriterienbasierten Erstellen einer, virtuelle Fahrzeugumgebungen aufweisenden, Szenarien-Bibliothek zum Testen hochautomatisierter Fahrfunktionen eines Kraftfahrzeugs.

### Stand der Technik

Ziel bei der Entwicklung und dem virtuellen Testen hochautomatisierter Fahrfunktionen eines Kraftfahrzeugs ist es, eine möglichst exakte Abdeckung sämtlicher, im realen Straßenverkehr auftretenden Fahrsituationen zu erreichen.

EP 3792768 A1 offenbart ein Verfahren zum Aufbau einer Testszenariobibliothek, umfassend ein Bestimmen von Szenariokategorien von Szenarioelementen, wobei die Szenariokategorien einen Wahrnehmungs-Typ oder einen Policy-Typ umfassen, ein Auswählen von Elementen des Policy-Typs aus den Szenario-Elementen, jeweils mit der bestimmten Szenario-Kategorie, ein Konstruieren einer Testszenariobibliothek gemäß den Policy-Typ-Elementen und ein Verifizieren der Testszenariobibliothek und Aktualisieren der Testszenariobibliothek gemäß einem Verifikationsergebnis.

Um eine Homologationsaussage betreffend eine ausreichende Testabdeckung der hochautomatisierten Fahrfunktionen eines Kraftfahrzeugs treffen zu können, ist es jedoch erforderlich, möglichst sämtliche, im realen Straßenverkehr auftretende Fahrsituationen zu erfassen, in eine Szenarien-Bibliothek aufzunehmen sowie virtuell zu testen.

Solche virtuellen Testszenarien, die für die Bewertung der hochautomatisierten Fahrfunktion bzw. eines hochautomatisierten Fahrsystems als Teil eines Sicherheitsnachweises verwendet werden, können daher aus den, im realen Straßenverkehr erfassten Fahrsituationen abgeleitet werden.

Um eine möglichst hohe Abdeckung der im realen Straßenverkehr auftretenden Fahrsituationen durch die Szenarien-Bibliothek zu erreichen ist es somit erforderlich, dass die Szenarien-Bibliothek eine ausreichende Anzahl von Datensätzen virtueller Testszenarien umfasst.

Demzufolge besteht ein Bedarf, bestehende Verfahren und Systeme zum Erstellen einer, virtuelle Fahrzeugumgebungen aufweisenden, Szenarien-Bibliothek zum Testen hochautomatisierter Fahrfunktionen eines Kraftfahrzeugs dahingehend zu verbessern, dass die Szenarien-Bibliothek eine optimale Testabdeckung der im realen Straßenverkehr auftretenden Fahrsituationen ermöglicht.

Es ist daher Aufgabe der Erfindung, ein computerimplementiertes Verfahren und System zum kriterienbasierten Erstellen einer, virtuelle Fahrzeugumgebungen aufweisenden, Szenarien-Bibliothek zum Testen hochautomatisierter Fahrfunktionen eines Kraftfahrzeugs bereitzustellen, welche die Erstellung einer, eine optimale Testabdeckung von im realen Straßenverkehr auftretenden Fahrsituationen aufweisende Szenarien-Bibliothek ermöglichen.

Ferner ist es Aufgabe der Erfindung, auf Basis der erstellten Szenarien-Bibliothek eine Modellgüte eines die automatisierte Fahrfunktion ausführenden Simulationsmodells zu validieren.

### Offenbarung der Erfindung

Die Aufgabe wird erfindungsgemäß durch ein computerimplementiertes Verfahren zum kriterienbasierten Erstellen einer, virtuelle Fahrzeugumgebungen aufweisenden, Szenarien-Bibliothek zum Testen hochautomatisierter Fahrfunktionen eines Kraftfahrzeugs mit den Merkmalen des Patentanspruchs 1 gelöst.

Des Weiteren wird die Aufgabe erfindungsgemäß durch ein computerimplementiertes Verfahren zur Validierung einer Modellgüte eines Simulationsmodells zum Ausführen eines virtuellen Tests einer hochautomatisierten Fahrfunktionen eines Kraftfahrzeugs mit den Merkmalen des Patentanspruchs 12 gelöst.

Darüber hinaus wird die Aufgabe erfindungsgemäß durch ein System zum kriterienbasierten Erstellen einer, virtuelle Fahrzeugumgebungen aufweisenden, Szenarien-Bibliothek zum Testen hochautomatisierter Fahrfunktionen eines Kraftfahrzeugs mit den Merkmalen des Patentanspruchs 14 gelöst.

Darüber hinaus wird die Aufgabe erfindungsgemäß durch ein Computerprogrammprodukt mit den Merkmalen des Patentanspruchs 15 gelöst.

Die Erfindung betrifft ein computerimplementiertes Verfahren zum kriterienbasierten Erstellen einer, virtuelle Fahrzeugumgebungen aufweisenden, Szenarien-Bibliothek zum Testen hochautomatisierter Fahrfunktionen eines Kraftfahrzeugs.

Das Verfahren umfasst ein Bereitstellen von, insbesondere vorerfassten, Sensordaten einer durch zumindest einen Umfelderkennungssensor erfassten Fahrt des Kraftfahrzeugs.

Des Weiteren umfasst das Verfahren ein Ermitteln, unter Verwendung vorgegebener Kriterien, eines, eine Fahrsituation von Interesse repräsentierenden, durch die Sensordaten umfassten ersten Szenario-Datensatzes.

Die Fahrsituation von Interesse ist durch einen Zeitabschnitt eines Datenstroms der Sensordaten gegeben, welche aus dem Datenstrom extrahiert und als, insbesondere abstrakter, erster Szenario-Datensatz abgespeichert oder zwischengespeichert wird.

Darüber hinaus umfasst das Verfahren ein Vergleichen des, die Fahrsituation von Interesse repräsentierenden ersten Szenario-Datensatzes mit von der Szenarien-Bibliothek umfassten, insbesondere abstrakten, zweiten Szenario-Datensätzen.

Das Verfahren umfasst ferner ein Erstellen eines, ein logisches Test-Szenario repräsentierenden dritten Szenario-Datensatzes (22) in der Szenarien-Bibliothek oder Erzeugen einer Aufforderung zum Erstellen des, das logische Test-Szenario repräsentierenden dritten Szenario-Datensatzes (22) in der Szenarien-Bibliothek, falls die durch den ersten Szenario-Datensatz ermittelte Fahrsituation von Interesse durch keinen der durch die Szenarien-Bibliothek umfassten zweiten Szenario-Datensätze abgedeckt ist.

Die Erfindung betrifft ferner ein computerimplementiertes Verfahren zur Validierung einer Modellgüte eines Simulationsmodells zum Ausführen eines virtuellen Tests einer hochautomatisierten Fahrfunktionen eines Kraftfahrzeugs.

Das Verfahren umfasst ein Bereitstellen eines aus Sensordaten einer durch zumindest einen Umfelderkennungssensor erfassten Fahrt des Kraftfahrzeugs extrahierten ersten Szenario-Datensatzes.

Des Weiteren umfasst das Verfahren ein Bereitstellen eines durch eine Szenarien-Bibliothek zum Testen hochautomatisierter Fahrfunktionen eines Kraftfahrzeugs umfassten dritten Szenario-Datensatzes.

Das Verfahren umfasst überdies ein Ausführen eines virtuellen Tests des durch den dritten Szenario-Datensatz umfassten Test-Szenarios unter Verwendung des Simulationsmodells.

Darüber hinaus umfasst das Verfahren ein Vergleichen des aus den Sensordaten der durch den zumindest einen Umfelderkennungssensor erfassten Fahrt des Kraftfahrzeugs extrahierten ersten Szenario-Datensatzes mit einer Ausgabe des Simulationsmodells.

Die Erfindung betrifft ferner ein System zum kriterienbasierten Erstellen einer, virtuelle Fahrzeugumgebungen aufweisenden, Szenarien-Bibliothek zum Testen hochautomatisierter Fahrfunktionen eines Kraftfahrzeugs. Das System umfasst zumindest einen Umfelderkennungssensor, welcher dazu eingerichtet ist, insbesondere vorerfasste, Sensordaten einer Fahrt des Kraftfahrzeugs bereitzustellen.

Des Weiteren umfasst das System eine Ermittlungseinheit, welche dazu eingerichtet ist, unter Verwendung vorgegebener Kriterien, einen, eine Fahrsituation von Interesse repräsentierenden, durch die Sensordaten umfassten, insbesondere abstrakten, ersten Szenario-Datensatz zu ermitteln.

Das System umfasst darüber hinaus eine Vergleichseinheit, welche dazu eingerichtet ist, den die Fahrsituation von Interesse repräsentierenden ersten Szenario-Datensatz mit von der Szenarien-Bibliothek umfassten, insbesondere abstrakten, zweiten Szenario-Datensätzen zu vergleichen.

Ferner umfasst das System eine Erzeugungseinheit, welche dazu eingerichtet ist, einen, ein logisches Test-Szenario repräsentierenden dritten Szenario-Datensatz (22) in der Szenarien-Bibliothek zu erstellen oder eine Aufforderung zum Erstellen des, das logische Test-Szenario repräsentierenden dritten Szenario-Datensatzes (22) in der Szenarien-Bibliothek zu erzeugen, falls die durch den ersten Szenario-Datensatz ermittelte Fahrsituation von Interesse durch keinen der durch die Szenarien-Bibliothek umfassten zweiten Szenario-Datensätze abgedeckt ist.

Die Erfindung betrifft überdies ein Computerprogrammprodukt mit einem Computerprogramm, das Softwaremittel zur Durchführung des erfindungsgemäßen Verfahrens umfasst, wobei das Computerprogramm auf einem Computer ausgeführt wird.

Ein Szenario ist als eine zeitliche Entwicklung einer Reihe von Szenen definiert. Eine Szene wird als eine Momentaufnahme der Umgebung, inklusive dynamischer und statischer Objekte, interpretiert. Jedes Szenario startet mit einer initialen Szene und wird durch Aktionen und Ereignisse dieser Objekte zeitlich entwickelt.

Abstrakte Szenarien sind aus funktionalen Szenarien abgeleitet. Dafür wird das informelle Szenario maschinenlesbar notiert. Dies ist möglich, indem man die auftretenden Relationen und Einschränkungen des Szenarios identifiziert und an eine Ontologie bindet. Eine Ontologie ist im Wesentlichen ein digitales Werkzeug zum Speichern von Wissen über Eigenschaften und Relationen zwischen Entitäten.

Entitäten sind die im Verkehr vorkommenden Akteure. Wenn man die im abstrakten Szenario definierten Relationen und Constraints parametrisiert und auf Wertebereiche mit entsprechenden Verteilungen der Parameter beschränkt, erhält man ein logisches Szenario.

Wählt man aus diesen Wertebereichen des logischen Szenarios jeweils einen validen Wert aus und instanziiert so diese Relationen und Constraints konkret, erhält man ein konkretes Szenario.

Aus einem abstrakten Szenario lassen sich also im Prinzip unendlich viele verschiedene logische Szenarien ableiten, dementsprechend auch unendlich viele konkrete Szenarien.

Eine Idee der vorliegenden Erfindung ist es, eine Szenarien-Bibliothek unter Verwendung von Szenario-Datensätzen zu erstellen, welche eine optimale Testabdeckung der im realen Straßenverkehr auftretenden Fahrsituationen ermöglicht.

Um dies zu erreichen, ist es von entscheidender Bedeutung, nach vorgegebenen Kriterien zu bestimmen, welche Szenario-Datensätze in die Szenarien-Bibliothek aufzunehmen sind und welche nicht.

Somit kann eine Abdeckung einer Test-Szenarien Taxonomie mit Aufnahme jedes weiteren, ein logisches Test-Szenario repräsentierenden Szenario-Datensatzes vervollständigt werden.

Das logische Test-Szenario kann sodann durch einen Simulator z.B. im Rahmen eines Szenario-basierten Tests simuliert werden.

Somit kann sicher und nachvollziehbar argumentiert werden, dass die automatisierte Fahrfunktion ausreichend sicher ist. Das erfindungsgemäße Verfahren ermöglicht auf eine methodisch nachvollziehbare Art und Weise die Bestimmung des Restrisikos sowie den Nachweis und die Quantifizierung der Test-Abdeckung. Dies stellt ein Kern-Problem bei der Zulassung von automatischen Fahrfunktionen dar.

Weitere Ausführungsformen der vorliegenden Erfindung sind Gegenstand der weiteren Unteransprüche und der nachfolgenden Beschreibung unter Bezugnahme auf die Figuren.

Gemäß einer bevorzugten Weiterbildung umfasst das Verfahren, dass der erste Szenario-Datensatz durch einen Zeitabschnitt eines durch die Sensordaten umfassten Datenstroms gebildet ist, und wobei die durch die Szenarien-Bibliothek umfassten zweiten Szenario-Datensätze durch eine maschinenlesbare, abstrakte Beschreibung einer Verkehrssituation von Interesse, insbesondere eines Test-Szenarios, gebildet ist.

Die abstrakte Beschreibung der Verkehrssituation von Interesse wird auch als abstraktes Szenario bzw. abstraktes Test-Szenario bezeichnet. Der Zeitabschnitt des durch die Sensordaten umfassten Datenstroms kann daher mit der maschinenlesbaren, abstrakten Beschreibung der Verkehrssituation von Interesse verglichen werden.

Gemäß einer weiteren bevorzugten Weiterbildung umfasst das Verfahren, dass falls nach Auswertung einer, einer bestimmten Fahrleistung des Kraftfahrzeugs entsprechenden, vorgegebenen Menge von Sensordaten jeder ermittelte erste Szenario-Datensatz durch die von der Szenarien-Bibliothek umfassten zweiten Szenario-Datensätze abgedeckt ist, eine, eine Vollständigkeit der Szenarien-Bibliothek bestätigende Nachricht erzeugt wird.

Damit kann demzufolge eine ausreichende Testung der automatisierten Fahrfunktion nachgewiesen werden, da eine Restwahrscheinlichkeit eines Auftretens neuer, durch die Szenarien-Bibliothek nicht umfasster Test-Szenarien mit zunehmender Menge ausgewerteter Sensordaten immer geringer wird.

Gemäß einer weiteren bevorzugten Weiterbildung umfasst das Verfahren, dass falls der ermittelte, durch die Sensordaten umfasste, die Fahrsituation von Interesse repräsentierende erste Szenario-Datensatz durch einen der durch die Szenarien-Bibliothek umfassten zweiten Szenario-Datensätze nicht abgedeckt ist, aus dem ersten Szenario-Datensatz ein, ein abstraktes Szenario repräsentierender zweiter Szenario-Datensatz erzeugt wird.

Somit kann eine Abdeckung abstrakter Szenarien in der Szenarien-Bibliothek vervollständigt werden.

Gemäß einer weiteren bevorzugten Weiterbildung umfasst das Verfahren, dass der das logische Test-Szenario repräsentierende dritte Szenario-Datensatz in der Szenarien-Bibliothek abgespeichert wird. Auf Basis des, das logische Test-Szenario repräsentierenden, abgespeicherten Datensatzes kann sodann ein konkretes Test-Szenario erstellt werden.

Die Szenarien-Datenbank umfasst damit abstrakte Szenarien und logische Test-Szenarien, die ggf. verlinkt sein können, jedoch unterschiedliche Datensätze sind.

Gemäß einer weiteren bevorzugten Weiterbildung umfasst das Verfahren, dass in der Szenarien-Bibliothek zu den zweiten Szenario-Datensätzen und/oder den dritten Szenario-Datensätzen Metadaten, insbesondere Informationen zu einer Datei der Sensordaten, zu Randbedingungen der Verkehrssituationen und/oder welchem von der Szenarien-Bibliothek umfassten zweiten Szenario-Datensätzen der ermittelte, die Fahrsituation von Interesse repräsentierende, durch die Sensordaten umfasste erste Szenario-Datensatz zugehörig ist, und Szenario-Parameter, insbesondere eine Geschwindigkeit zumindest eines Kraftfahrzeugs und/oder ein Abstand zwischen Kraftfahrzeugen, abgespeichert sind. Die oben genannten Szenario-Parameter sind lediglich beispielhaft aufgeführt. Denkbar ist der Einsatz einer Vielzahl weiterer bekannter Szenario-Parameter. Unter Verwendung der Metadaten kann somit eine Relation zwischen den ersten und zweiten Szenario-Datensätzen hergestellt werden.

Gemäß einer weiteren bevorzugten Weiterbildung umfasst das Verfahren, dass der das logische Test-Szenario repräsentierende dritte Szenario-Datensatz unter Verwendung eines Algorithmus erzeugt wird, welcher Sensordaten und ein durch die Sensordaten umfasstes, abstraktes Test-Szenario als Eingabedaten empfängt.

Bei dem Algorithmus handelt es sich vorzugsweise um einen Algorithmus des maschinellen Lernens wie beispielsweise ein neuronales Netz. Die Sensordaten können z.B. Kamerabilddaten, Radarbilddaten oder LiDAR-Daten sein.

Gemäß einer weiteren bevorzugten Weiterbildung umfasst das Verfahren, dass das Ermitteln des, die Fahrsituation von Interesse repräsentierenden, durch die Sensordaten umfassten ersten Szenario-Datensatzes durch Klassifizieren einer Fahrsituation von Interesse in abstrakte Szenarien repräsentierende Klassen durchgeführt wird. Somit kann in vorteilhafter Weise eine automatisierte Extraktion bzw. Bestimmung abstrakter Szenarien auf Basis der zugrundeliegenden Sensordaten erfolgen.

Gemäß einer weiteren bevorzugten Weiterbildung umfasst das Verfahren, dass das Ermitteln, unter Verwendung vorgegebener Kriterien, des die Fahrsituation von Interesse repräsentierenden, durch die Sensordaten umfassten ersten Szenario-Datensatzes und das Vergleichen des, die Fahrsituation von Interesse repräsentierenden ersten Szenario-Datensatzes mit von der Szenarien-Bibliothek umfassten zweiten Szenario-Datensätzen derart kombinierbar sind, dass im Schritt des Vergleichens ein Filtern der Sensordaten unter Verwendung der vorgegebenen Kriterien durchgeführt wird.

Das Filtern der Sensordatenstroms nach den vorgegebenen Kriterien ermöglicht somit in vorteilhafter Weise ein Identifizieren relevanter Fahrsituationen von Interesse.

Gemäß einer weiteren bevorzugten Weiterbildung umfasst das Verfahren, dass ein Bestimmen der vorgegebenen Kriterien zum Ermitteln des, die Fahrsituation von Interesse repräsentierenden, durch die Sensordaten umfassten ersten Szenario-Datensatzes unter Verwendung einer Systemschwächenanalyse durchgeführt wird.

Mit der Systemschwächenanalyse bzw. System Weakness Analysis kann man deduktiv Schwächen des Systems identifizieren und sogenannte Triggering Conditions, d.h. Situationen, Kombinationen von Paramatern oder Szenen, die potenziell zu gefährdenden Situationen oder Systemdegradationen führen können, identifizieren, welche die Grundlage für die Definition von Key Performance Indikatoren (KPIs) bilden.

Da nur zu manchen Zeiten in den Testfahrten relevante Situation auftreten, filtert man die Messdaten in einem ersten Schritt, d.h. dem Schritt des Ermittelns, unter Verwendung vorgegebener Kriterien, des, die Fahrsituation von Interesse repräsentierenden, durch die Sensordaten umfassten ersten Szenario-Datensatzes, anhand von definierten KPIs. Diese KPIs ergeben sich aus der vorgelagerten Systemschwächenanalyse. Alternativ können hierfür andere Verfahren zur Risikoanalyse wie beispielsweise FTA oder FTMA eingesetzt werden.

Gemäß einer weiteren bevorzugten Weiterbildung umfasst das Verfahren, dass die Szenarien-Bibliothek Daten einer Test-Szenarien Taxonomie, insbesondere einer Test-Szenarien ODD-Taxonomie, umfasst, und wobei die Test-Szenarien-Taxonomie auf ein spezifisches, zu testendes System ausgerichtet ist.

Die Test-Szenarien-Taxonomie definiert somit die zu erreichende Testabdeckung, welche bei Erreichen das Treffen einer Homologationsaussage im Hinblick auf eine ausreichende Testabdeckung der hochautomatisierten Fahrfunktionen des Kraftfahrzeugs ermöglicht.

Gemäß einer weiteren bevorzugten Weiterbildung umfasst das Verfahren, dass falls wobei falls der aus den Sensordaten der durch den zumindest einen Umfelderkennungssensor erfassten Fahrt des Kraftfahrzeugs extrahierte erste Szenario-Datensatz und die Ausgabe des Simulationsmodells eine, ein vorgegebenes Maß übersteigende Ähnlichkeit aufweisen, eine Validität des Algorithmus zum Ausführen der hochautomatisierten Fahrfunktionen des Kraftfahrzeugs bestätigt wird.

Somit kann verglichen werden, wie sich das unter Verwendung der zweiten Szenario-Datensätze trainierte, die hochautomatisierte Fahrfunktion des Kraftfahrzeugs ausführende Modell in einem virtuellen Test im Vergleich zu den aus realen Testfahrten gewonnenen Verkehrssituationen verhält.

Die hierin beschriebenen Merkmale des computerimplementierten Verfahrens zum kriterienbasierten Erstellen einer, virtuelle Fahrzeugumgebungen aufweisenden, Szenarien-Bibliothek zum Testen hochautomatisierter Fahrfunktionen eines Kraftfahrzeugs sind ebenso auf das System zum kriterienbasierten Erstellen einer, virtuelle Fahrzeugumgebungen aufweisenden, Szenarien-Bibliothek zum Testen hochautomatisierter Fahrfunktionen eines Kraftfahrzeugs und umgekehrt offenbart.

### Kurze Beschreibung der Zeichnungen

Zum besseren Verständnis der vorliegenden Erfindung und ihrer Vorteile wird nun auf die nachfolgende Beschreibung in Verbindung mit den zugehörigen Zeichnungen verwiesen. Nachfolgend wird die Erfindung anhand exemplarischer Ausführungsformen näher erläutert, die in den schematischen Abbildungen der Zeichnungen angegeben sind.

Es zeigen:
- Fig. 1: ein Ablaufdiagramm eines computerimplementierten Verfahrens zum kriterienbasierten Erstellen einer, virtuelle Fahrzeugumgebungen aufweisenden, Szenarien-Bibliothek zum Testen hochautomatisierter Fahrfunktionen eines Kraftfahrzeugs gemäß einer bevorzugten Ausführungsform der Erfindung;
- Fig. 2: ein Ablaufdiagramm eines computerimplementierten Verfahrens zur Validierung einer Modellgüte eines Simulationsmodells zum Ausführen eines virtuellen Tests einer hochautomatisierten Fahrfunktionen eines Kraftfahrzeugs gemäß der bevorzugten Ausführungsform der Erfindung; und
- Fig. 3: ein Diagramm eines Systems zum kriterienbasierten Erstellen einer, virtuelle Fahrzeugumgebungen aufweisenden, Szenarien-Bibliothek zum Testen hochautomatisierter Fahrfunktionen eines Kraftfahrzeugs gemäß der bevorzugten Ausführungsform der Erfindung.

Sofern nicht anders angegeben, bezeichnen gleiche Bezugszeichen gleiche Elemente der Zeichnungen.

### Ausführliche Beschreibung der Ausführungsformen

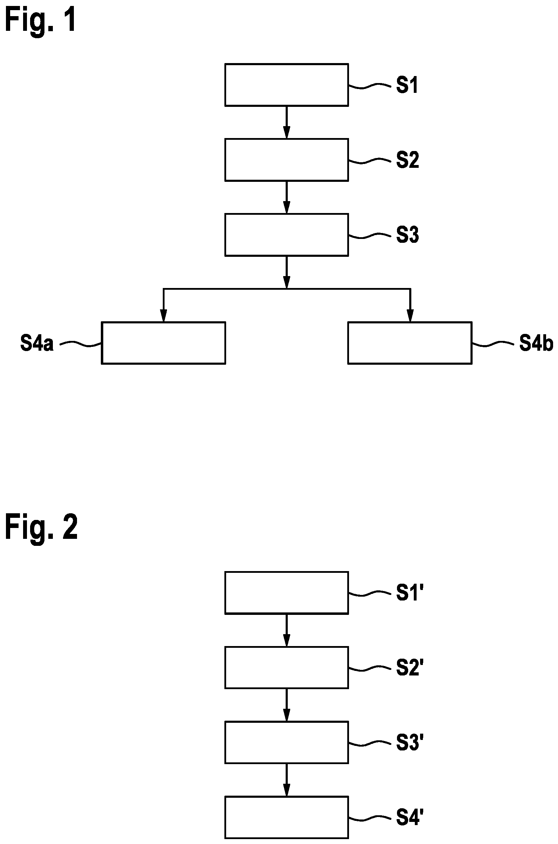

Fig. 1 zeigt ein Ablaufdiagramm eines Verfahrens zum kriterienbasierten Erstellen einer, virtuelle Fahrzeugumgebungen aufweisenden, Szenarien-Bibliothek 10 zum Testen hochautomatisierter Fahrfunktionen eines Kraftfahrzeugs.

Das Verfahren umfasst ein Bereitstellen S1 von, insbesondere vorerfassten, Sensordaten 12 einer durch zumindest einen Umfelderkennungssensor 26 erfassten Fahrt des Kraftfahrzeugs.

Der Umfelderkennungssensor 26 kann beispielsweise durch einen fahrzeugseitigen Umfelderkennungssensor ausgebildet sein. Alternativ kann der Umfelderkennungssensor 26 durch einen in einer Umgebung des Kraftfahrzeugs positionierten Umfelderkennungssensor ausgebildet sein. Ein solcher Umfelderkennungssensor kann z.B. an einem Gebäude, einem Verkehrszeichen, einer Ampel und/oder einer Drohne angebracht sein.

Des Weiteren umfasst das Verfahren ein Ermitteln S2, unter Verwendung vorgegebener Kriterien, eines, eine Fahrsituation von Interesse 14 repräsentierenden, durch die Sensordaten 12 umfassten, insbesondere abstrakten, ersten Szenario-Datensatzes 16 sowie ein Vergleichen S3 des, die Fahrsituation von Interesse 14 repräsentierenden ersten Szenario-Datensatzes 16 mit von der Szenarien-Bibliothek 10 umfassten, insbesondere abstrakten, zweiten Szenario-Datensätzen 18.

Darüber hinaus umfasst das Verfahren ein Erstellen S4a eines, ein logisches Test-Szenario repräsentierenden dritten Szenario-Datensatzes (22) in der Szenarien-Bibliothek 10 oder Erzeugen S4b einer Aufforderung zum Erstellen des, das logische Test-Szenario repräsentierenden dritten Szenario-Datensatzes (22) in der Szenarien-Bibliothek 10, falls die durch den ersten Szenario-Datensatz 16 ermittelte Fahrsituation von Interesse 14 durch keinen der durch die Szenarien-Bibliothek 10 umfassten zweiten Szenario-Datensätze 18 abgedeckt ist.

Der erste Szenario-Datensatz 16 ist durch einen Zeitabschnitt eines durch die Sensordaten 12 umfassten Datenstroms gebildet. Die durch die Szenarien-Bibliothek 10 umfassten zweiten Szenario-Datensätze 18 sind ferner durch eine maschinenlesbare, abstrakte Beschreibung einer Verkehrssituation von Interesse, insbesondere eines Test-Szenarios, gebildet.

Falls nach Auswertung einer, einer bestimmten Fahrleistung des Kraftfahrzeugs entsprechenden, vorgegebenen Menge von Sensordaten 12 jeder ermittelte erste Szenario-Datensatz 16 durch die von der Szenarien-Bibliothek 10 umfassten zweiten Szenario-Datensätze 18 abgedeckt ist, wird eine, eine Vollständigkeit der Szenarien-Bibliothek 10 bestätigende Nachricht 20 erzeugt.

Falls ferner der ermittelte, durch die Sensordaten 12 umfasste, die Fahrsituation von Interesse 14 repräsentierende erste Szenario-Datensatz 16 durch einen der durch die Szenarien-Bibliothek 10 umfassten zweiten Szenario-Datensätze 18 nicht abgedeckt ist, wird aus dem ersten Szenario-Datensatz 16 ein, ein abstraktes Szenario repräsentierender zweiter Szenario-Datensatz 22 erzeugt. Der das logische Test-Szenario repräsentierende dritte Szenario-Datensatz 22 wird sodann in der Szenarien-Bibliothek 10 abgespeichert.

In der Szenarien-Bibliothek 10 sind zu den zweiten Szenario-Datensätzen 18 und/oder den dritten Szenario-Datensätzen Metadaten, insbesondere Informationen zu einer Datei der Sensordaten 12, zu Randbedingungen der Verkehrssituationen und/oder welchem von der Szenarien-Bibliothek 10 umfassten zweiten Szenario-Datensätzen 18 der ermittelte, die Fahrsituation von Interesse 14 repräsentierende, durch die Sensordaten 12 umfasste erste Szenario-Datensatz 16 zugehörig ist, und Szenario-Parameter, insbesondere eine Geschwindigkeit zumindest eines Kraftfahrzeugs und/oder ein Abstand zwischen Kraftfahrzeugen, abgespeichert.

Der das logische Test-Szenario repräsentierende dritte Szenario-Datensatz 22 wird unter Verwendung eines Algorithmus erzeugt, welcher Sensordaten 12 und ein durch die Sensordaten 12 umfasstes, abstraktes Test-Szenario als Eingabedaten empfängt.

Das Ermitteln S2 des, die Fahrsituation von Interesse 14 repräsentierenden, durch die Sensordaten 12 umfassten ersten Szenario-Datensatzes 16 wird durch Klassifizieren einer Fahrsituation von Interesse 14 in abstrakte Szenarien repräsentierende Klassen durchgeführt.

Des Weiteren sind das Ermitteln S2, unter Verwendung vorgegebener Kriterien, des die Fahrsituation von Interesse 14 repräsentierenden, durch die Sensordaten 12 umfassten ersten Szenario-Datensatzes 16 und das Vergleichen S3 des, die Fahrsituation von Interesse 14 repräsentierenden ersten Szenario-Datensatzes 16 mit von der Szenarien-Bibliothek 10 umfassten zweiten Szenario-Datensätzen 18 derart kombinierbar, dass im Schritt des Vergleichens S3 ein Filtern der Sensordaten 12 unter Verwendung der vorgegebenen Kriterien durchgeführt wird.

Ferner wird ein Bestimmen der vorgegebenen Kriterien zum Ermitteln des, die Fahrsituation von Interesse 14 repräsentierenden, durch die Sensordaten 12 umfassten ersten Szenario-Datensatzes 16 unter Verwendung einer Systemschwächenanalyse durchgeführt.

Die Szenarien-Bibliothek 10 umfasst Daten einer Test-Szenarien Taxonomie, insbesondere einer Test-Szenarien ODD-Taxonomie. Die Test-Szenarien-Taxonomie ist dabei auf ein spezifisches, zu testendes System 24 ausgerichtet, beispielsweise auf eine spezifische automatisierte Fahrfunktion und/oder System.

Fig. 2 zeigt ein Ablaufdiagramm eines computerimplementierten Verfahrens zur Validierung einer Modellgüte eines Simulationsmodells zum Ausführen eines virtuellen Tests einer hochautomatisierten Fahrfunktionen eines Kraftfahrzeugs gemäß der bevorzugten Ausführungsform der Erfindung.

Das Verfahren umfasst ein Bereitstellen S1' eines aus Sensordaten 12 einer durch zumindest einen Umfelderkennungssensor 26 erfassten Fahrt des Kraftfahrzeugs extrahierten ersten Szenario-Datensatzes 16.

Des Weiteren umfasst das Verfahren ein Bereitstellen S2` eines durch eine Szenarien-Bibliothek 10 zum Testen hochautomatisierter Fahrfunktionen eines Kraftfahrzeugs umfassten dritten Szenario-Datensatzes 22.

Das Verfahren umfasst überdies ein Ausführen S3' eines virtuellen Tests des durch den dritten Szenario-Datensatz 22 umfassten Test-Szenarios unter Verwendung des Simulationsmodells.

Darüber hinaus umfasst das Verfahren ein Vergleichen S4` des aus den Sensordaten 12 der durch den zumindest einen Umfelderkennungssensor 26 erfassten Fahrt des Kraftfahrzeugs extrahierten ersten Szenario-Datensatzes 16 mit einer Ausgabe des Simulationsmodells.

Falls der aus den Sensordaten 12 der durch den zumindest einen Umfelderkennungssensor 26 erfassten Fahrt des Kraftfahrzeugs extrahierte erste Szenario-Datensatz und die Ausgabe des Simulationsmodells eine, ein vorgegebenes Maß übersteigende Ähnlichkeit aufweisen, wird eine Validität des Algorithmus zum Ausführen der hochautomatisierten Fahrfunktionen des Kraftfahrzeugs bestätigt.

Die Validierung des Simulationsmodells erfolgt somit unter Verwendung des dritten Szenario-Datensatzes bzw. einer Mehrzahl dritter Szenario-Datensätze in einem Simulator.

Weitere bevorzugte Ausführungsformen:
Gemäß einer weiteren bevorzugten Ausführungsform ist vorgesehen, dass nach jeder Generierung eines, ein logisches Test-Szenario repräsentierenden, dritten Szenario-Datensatzes ein Ausführen S3' des virtuellen Tests des durch den dritten Szenario-Datensatz 22 umfassten Test-Szenarios unter Verwendung des Simulationsmodells durchgeführt wird.

Gemäß einer weiteren bevorzugten Ausführungsform ist vorgesehen, dass nach jeder Generierung des, das logische Test-Szenario repräsentierenden, dritten Szenario-Datensatzes der Vergleich des aus den Sensordaten 12 der durch den zumindest einen Umfelderkennungssensor 26 erfassten Fahrt des Kraftfahrzeugs extrahierten ersten Szenario-Datensatzes 16 mit einer Ausgabe des Simulationsmodells durchgeführt wird.

So weist man nach, dass das verwendete Modell valide ist und das logische Szenario, welches als Grundlage für das Szenario-Basierte Testen verwendet wird, im Gültigkeitsbereich des Simulationsmodells liegt.

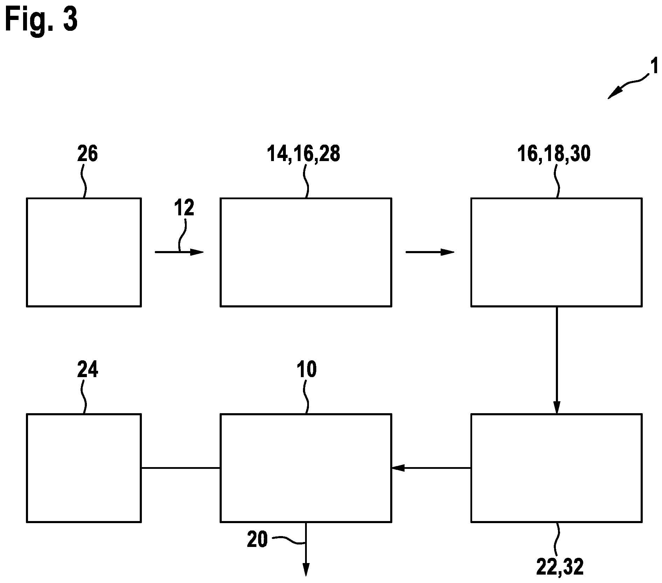

Fig. 3 zeigt ein Diagramm eines Systems zum kriterienbasierten Erstellen einer, virtuelle Fahrzeugumgebungen aufweisenden, Szenarien-Bibliothek 10 zum Testen hochautomatisierter Fahrfunktionen eines Kraftfahrzeugs gemäß der bevorzugten Ausführungsform der Erfindung.

Das System umfasst zumindest einen Umfelderkennungssensor 26, welcher dazu eingerichtet ist, insbesondere vorerfasste, Sensordaten 12 einer Fahrt des Kraftfahrzeugs bereitzustellen.

Ferner umfasst das System eine Ermittlungseinheit 28, welche dazu eingerichtet ist, unter Verwendung vorgegebener Kriterien, einen, eine Fahrsituation von Interesse 14 repräsentierenden, durch die Sensordaten 12 umfassten, insbesondere abstrakten, ersten Szenario-Datensatz 16 zu ermitteln sowie eine Vergleichseinheit 30, welche dazu eingerichtet ist, den die Fahrsituation von Interesse 14 repräsentierenden ersten Szenario-Datensatz 16 mit von der Szenarien-Bibliothek 10 umfassten, insbesondere abstrakten, zweiten Szenario-Datensätzen 18 zu vergleichen.

Das System umfasst des Weiteren eine Erzeugungseinheit 32, welche dazu eingerichtet ist, einen, ein logisches Test-Szenario repräsentierenden dritten Szenario-Datensatz (22) in der Szenarien-Bibliothek 10 zu erstellen oder eine Aufforderung zum Erstellen des, das logische Test-Szenario repräsentierenden dritten Szenario-Datensatzes (22) in der Szenarien-Bibliothek 10 zu erzeugen, falls die durch den ersten Szenario-Datensatz 16 ermittelte Fahrsituation von Interesse 14 durch keinen der durch die Szenarien-Bibliothek 10 umfassten zweiten Szenario-Datensätze 18 abgedeckt ist.

Obwohl hierin spezifische Ausführungsformen illustriert und beschrieben wurden, ist es dem Fachmann verständlich, dass eine Vielzahl von alternativen und/oder äquivalenten Implementierungen existieren. Es sollte beachtet werden, dass die beispielhafte Ausführungsform oder beispielhaften Ausführungsformen nur Beispiele sind und nicht dazu dienen, den Umfang, die Anwendbarkeit oder die Konfiguration in irgendeiner Weise einzuschränken.

Vielmehr liefert die vorstehend genannte Zusammenfassung und ausführliche Beschreibung dem Fachmann eine bequeme Anleitung zur Implementierung zumindest einer beispielhaften Ausführungsform, wobei verständlich ist, dass verschiedene Änderungen im Funktionsumfang und der Anordnung der Elemente vorgenommen werden können, ohne vom Umfang der beigefügten Ansprüche und ihrer rechtlichen Äquivalente abzuweichen.

Im Allgemeinen beabsichtigt diese Anmeldung, Änderungen bzw. Anpassungen oder Variationen der hierin dargestellten Ausführungsformen abzudecken.

Beispielsweise kann eine Reihenfolge der Verfahrensschritte abgeändert werden. Das Verfahren kann ferner zumindest abschnittsweise sequentiell oder parallel durchgeführt werden.

### Bezugszeichenliste

- 1: System
- 10: Szenarien-Bibliothek
- 12: Sensordaten
- 14: Fahrsituation von Interesse
- 16: erster Szenario-Datensatz
- 18: zweiter Szenario-Datensatz
- 20: Nachricht
- 22: dritter Szenario-Datensatz
- 24: zu testendes System
- 26: Umfelderkennungssensor
- 28: Ermittlungseinheit
- 30: Vergleichseinheit
- 32: Erzeugungseinheit
- S1-S4b: Verfahrensschritte
- S1`-S4`: Verfahrensschritte

## Patentansprüche

1. Computerimplementiertes Verfahren zum kriterienbasierten Erstellen einer, virtuelle Fahrzeugumgebungen aufweisenden, Szenarien-Bibliothek (10) zum Testen hochautomatisierter Fahrfunktionen eines Kraftfahrzeugs, mit den Schritten:
Bereitstellen (S1) von, insbesondere vorerfassten, Sensordaten (12) einer durch zumindest einen Umfelderkennungssensor (26) erfassten Fahrt des Kraftfahrzeugs;
Ermitteln (S2), unter Verwendung vorgegebener Kriterien, eines, eine Fahrsituation von Interesse (14) repräsentierenden, durch die Sensordaten (12) umfassten, insbesondere abstrakten, ersten Szenario-Datensatzes (16);
Vergleichen (S3) des, die Fahrsituation von Interesse (14) repräsentierenden ersten Szenario-Datensatzes (16) mit von der Szenarien-Bibliothek (10) umfassten, insbesondere abstrakten, zweiten Szenario-Datensätzen (18); und
Erstellen (S4a) eines, ein logisches Test-Szenario repräsentierenden dritten Szenario-Datensatzes (22) in der Szenarien-Bibliothek (10) oder Erzeugen (S4b) einer Aufforderung zum Erstellen des, das logische Test-Szenario repräsentierenden dritten Szenario-Datensatzes (22) in der Szenarien-Bibliothek (10), falls die durch den ersten Szenario-Datensatz (16) ermittelte Fahrsituation von Interesse (14) durch keinen der durch die Szenarien-Bibliothek (10) umfassten zweiten Szenario-Datensätze (18) abgedeckt ist.

2. Computerimplementiertes Verfahren nach Anspruch 1, wobei der erste Szenario-Datensatz (16) durch einen Zeitabschnitt eines durch die Sensordaten (12) umfassten Datenstroms gebildet ist, und wobei die durch die Szenarien-Bibliothek (10) umfassten zweiten Szenario-Datensätze (18) durch eine maschinenlesbare, abstrakte Beschreibung einer Verkehrssituation von Interesse, insbesondere eines Test-Szenarios, gebildet ist.

3. Computerimplementiertes Verfahren nach Anspruch 1 oder 2, wobei falls nach Auswertung einer, einer bestimmten Fahrleistung des Kraftfahrzeugs entsprechenden, vorgegebenen Menge von Sensordaten (12) jeder ermittelte erste Szenario-Datensatz (16) durch die von der Szenarien-Bibliothek (10) umfassten zweiten Szenario-Datensätze (18) abgedeckt ist, eine, eine Vollständigkeit der Szenarien-Bibliothek (10) bestätigende Nachricht (20) erzeugt wird.

4. Computerimplementiertes Verfahren nach einem der vorhergehenden Ansprüche, wobei falls der ermittelte, durch die Sensordaten (12) umfasste, die Fahrsituation von Interesse (14) repräsentierende erste Szenario-Datensatz (16) durch einen der durch die Szenarien-Bibliothek (10) umfassten zweiten Szenario-Datensätze (18) nicht abgedeckt ist, aus dem ersten Szenario-Datensatz (16) ein, ein abstraktes Szenario repräsentierender zweiter Szenario-Datensatz (18) erzeugt wird.

5. Computerimplementiertes Verfahren nach einem der vorhergehenden Ansprüche, wobei der das logische Test-Szenario repräsentierende dritte Szenario-Datensatz (22) in der Szenarien-Bibliothek (10) abgespeichert wird.

6. Computerimplementiertes Verfahren nach einem der vorhergehenden Ansprüche, wobei in der Szenarien-Bibliothek (10) zu den zweiten Szenario-Datensätzen (18) und/oder den dritten Szenario-Datensätzen (22) Metadaten, insbesondere Informationen zu einer Datei der Sensordaten (12), zu Randbedingungen der Verkehrssituationen und/oder welchem von der Szenarien-Bibliothek (10) umfassten zweiten Szenario-Datensätzen (18) der ermittelte, die Fahrsituation von Interesse (14) repräsentierende, durch die Sensordaten (12) umfasste erste Szenario-Datensatz (16) zugehörig ist, und Szenario-Parameter, insbesondere eine Geschwindigkeit zumindest eines Kraftfahrzeugs und/oder ein Abstand zwischen Kraftfahrzeugen, abgespeichert sind.

7. Computerimplementiertes Verfahren nach einem der vorhergehenden Ansprüche, wobei der das logische Test-Szenario repräsentierende dritte Szenario-Datensatz (22) unter Verwendung eines Algorithmus erzeugt wird, welcher Sensordaten (12) und ein durch die Sensordaten (12) umfasstes, abstraktes Test-Szenario als Eingabedaten empfängt.

8. Computerimplementiertes Verfahren nach einem der vorhergehenden Ansprüche, wobei das Ermitteln (S2) des, die Fahrsituation von Interesse (14) repräsentierenden, durch die Sensordaten (12) umfassten ersten Szenario-Datensatzes (16) durch Klassifizieren einer Fahrsituation von Interesse (14) in abstrakte Szenarien repräsentierende Klassen durchgeführt wird.

9. Computerimplementiertes Verfahren nach einem der vorhergehenden Ansprüche, wobei das Ermitteln (S2), unter Verwendung vorgegebener Kriterien, des die Fahrsituation von Interesse (14) repräsentierenden, durch die Sensordaten (12) umfassten ersten Szenario-Datensatzes (16) und das Vergleichen (S3) des, die Fahrsituation von Interesse (14) repräsentierenden ersten Szenario-Datensatzes (16) mit von der Szenarien-Bibliothek (10) umfassten zweiten Szenario-Datensätzen (18) derart kombinierbar sind, dass im Schritt des Vergleichens (S3) ein Filtern der Sensordaten (12) unter Verwendung der vorgegebenen Kriterien durchgeführt wird.

10. Computerimplementiertes Verfahren nach einem der vorhergehenden Ansprüche, wobei ein Bestimmen der vorgegebenen Kriterien zum Ermitteln des, die Fahrsituation von Interesse (14) repräsentierenden, durch die Sensordaten (12) umfassten ersten Szenario-Datensatzes (16) unter Verwendung einer Systemschwächenanalyse durchgeführt wird.

11. Computerimplementiertes Verfahren nach einem der vorhergehenden Ansprüche, wobei die Szenarien-Bibliothek (10) Daten einer Test-Szenarien Taxonomie, insbesondere einer Test-Szenarien ODD-Taxonomie, umfasst, und wobei die Test-Szenarien-Taxonomie auf ein spezifisches, zu testendes System (24) ausgerichtet ist.

12. Computerimplementiertes Verfahren zur Validierung einer Modellgüte eines Simulationsmodells zum Ausführen eines virtuellen Tests einer hochautomatisierten Fahrfunktionen eines Kraftfahrzeugs, mit den Schritten:
Bereitstellen (S1') eines aus Sensordaten (12) einer durch zumindest einen Umfelderkennungssensor (26) erfassten Fahrt des Kraftfahrzeugs extrahierten ersten Szenario-Datensatzes (16);
Bereitstellen (S2') eines durch eine Szenarien-Bibliothek (10) zum Testen hochautomatisierter Fahrfunktionen eines Kraftfahrzeugs umfassten dritten Szenario-Datensatzes (22);
Ausführen (S3') eines virtuellen Tests des durch den dritten Szenario-Datensatz (22) umfassten Test-Szenarios unter Verwendung des Simulationsmodells; und
Vergleichen (S4') des aus den Sensordaten (12) der durch den zumindest einen Umfelderkennungssensor (26) erfassten Fahrt des Kraftfahrzeugs extrahierten ersten Szenario-Datensatzes (16) mit einer Ausgabe des Simulationsmodells.

13. Computerimplementiertes Verfahren nach Anspruch 12, wobei falls der aus den Sensordaten (12) der durch den zumindest einen Umfelderkennungssensor (26) erfassten Fahrt des Kraftfahrzeugs extrahierte erste Szenario-Datensatz und die Ausgabe des Simulationsmodells eine, ein vorgegebenes Maß übersteigende Ähnlichkeit aufweisen, eine Validität des Algorithmus zum Ausführen der hochautomatisierten Fahrfunktionen des Kraftfahrzeugs bestätigt wird.

14. System (1) zum kriterienbasierten Erstellen einer, virtuelle Fahrzeugumgebungen aufweisenden, Szenarien-Bibliothek (10) zum Testen hochautomatisierter Fahrfunktionen eines Kraftfahrzeugs, mit:
zumindest einem Umfelderkennungssensor (26), welcher dazu eingerichtet ist, insbesondere vorerfasste, Sensordaten (12) einer Fahrt des Kraftfahrzeugs bereitzustellen;
einer Ermittlungseinheit (28), welche dazu eingerichtet ist, unter Verwendung vorgegebener Kriterien, einen, eine Fahrsituation von Interesse (14) repräsentierenden, durch die Sensordaten (12) umfassten, insbesondere abstrakten, ersten Szenario-Datensatz (16) zu ermitteln;
einer Vergleichseinheit (30), welche dazu eingerichtet ist, den die Fahrsituation von Interesse (14) repräsentierenden ersten Szenario-Datensatz (16) mit von der Szenarien-Bibliothek (10) umfassten, insbesondere abstrakten, zweiten Szenario-Datensätzen (18) zu vergleichen; und
einer Erzeugungseinheit (32), welche dazu eingerichtet ist, einen, ein logisches Test-Szenario repräsentierenden dritten Szenario-Datensatz (22) in der Szenarien-Bibliothek (10) zu erstellen oder eine Aufforderung zum Erstellen des, das logische Test-Szenario repräsentierenden dritten Szenario-Datensatzes (22) in der Szenarien-Bibliothek (10) zu erzeugen, falls die durch den ersten Szenario-Datensatz (16) ermittelte Fahrsituation von Interesse (14) durch keinen der durch die Szenarien-Bibliothek (10) umfassten zweiten Szenario-Datensätze (18) abgedeckt ist.

15. Computerprogrammprodukt mit einem Computerprogramm, das Softwaremittel zur Durchführung des Verfahrens nach einem der Ansprüche 1 bis 11 und/oder des Verfahrens nach Anspruch 12 oder 13 umfasst, wobei das Computerprogramm auf einem Computer ausgeführt wird.
